# EUROPÄISCHE PATENTANMELDUNG

(11) **EP 2 369 640 A1**
(43) Veröffentlichungstag der Anmeldung: **28.09.2011**
(21) Anmeldenummer: 10157491.1
(22) Anmeldetag: 24.03.2010
(51) Int. Cl.: H01L 31/05, H01L 31/18

(54) **Verfahren zur Herstellung eines Solarmoduls**

(71) Anmelder: Scheuten S.à.r.l., 5916 PA Venlo (NL)
(72) Erfinder: Schuurmans, Frank, 5976 PD, Kronenberg (NL); van der Velden, Kees, 6133 VA, Sittard (NL); Beckers, Arthur, 6045 CB, Roermond (NL); Geyer, Volker, 52222 Stolberg (DE)
(74) Vertreter: Jostarndt, Hans-Dieter

(57) **Zusammenfassung**

Die vorliegende Erfindung betrifft ein Verfahren zur Herstellung eines Solarmoduls, bei dem ein elektrisch leitendes Verbindungsmotiv auf ein Substrat und insbesondere ein Substrat aus Glas aufgebracht wird, sodass Solarzellen auf dem Substrat, welches das Verbindungsmotiv umfasst, angeordnet werden können, wobei die Rückkontakte von mindestens zwei Solarzellen elektrisch leitend mit dem Verbindungsmotiv verbunden werden können, um eine Verschaltung der Solarzellen zu ermöglichen, wobei ferner eine Glasscheibe mit dem Substrat, welches das Verbindungsmotiv umfasst, und den darauf angeordneten Solarzellen vereinigt wird, um ein Solarmodul zu erhalten.

## Beschreibung

Die vorliegende Erfindung betrifft ein Verfahren zur Herstellung eines Solarmoduls, bei dem ein elektrisch leitendes Verbindungsmotiv auf ein Substrat und insbesondere ein Substrat aus Glas aufgebracht wird, sodass Solarzellen auf dem Substrat, welches das Verbindungsmotiv umfasst, angeordnet werden können, wobei die Rückkontakte von mindestens zwei Solarzellen elektrisch leitend mit dem Verbindungsmotiv verbunden werden können, um eine Verschaltung der Solarzellen zu ermöglichen, wobei ferner eine Glasscheibe mit dem Substrat, welches das Verbindungsmotiv umfasst, und den darauf angeordneten Solarzellen vereinigt wird, um ein Solarmodul zu erhalten.

Aus dem Stand der Technik sind dabei Verfahren zum Herstellen von Solarmodulen bekannt, bei denen eine EVA-Folie auf eine Glasscheibe gelegt wird, sodass Solarzellstränge (sogenannte Solarzellstrings), welche aus einzelnen Solarzellen insbesondere H-Bar-Solarzellen bestehen, die mit dünnen Metallstreifen (sogenannten Lötbändchen) und einem entsprechenden Lot verbunden werden, auf der über der Glasscheibe liegenden EVA-Folie positioniert werden. Die Verschaltung der Solarzellen in den Strings erfolgt dabei über die Lötbändchen. Anschließend werden Querverbinder mit den Strängen verbunden beziehungsweise verlötet und zum Ort der Anschlussdose geführt, um die Solarzellstränge miteinander zu verbinden und den erzeugten Strom abzuführen. Danach werden die Solarzellstrings mit einer EVA-Folie und einer Rückseitenabdeckung bedeckt, um einen mehrschichtigen Modulaufbau aus Glasscheibe, EVA-Folie, Solarzellstrings und Querverbindern, EVA-Folie und Rückseitenabdeckung zu erhalten. Schließlich wird der mehrschichtige Modulaufbau laminiert, insbesondere bei erhöhter Temperatur und/oder bei Unterdruck, um Glasscheibe und Rückseitenabdeckung durch die EVA-Schicht und den darin eingeschlossenen Solarzellstrings miteinander zu verbinden. Die Rückseitenabdeckung kann dabei zum Beispiel eine Glasscheibe oder Abdeckplatte sein.

Zum Herstellen der Solarzellstrings müssen die Solarzellen jedoch extensiv manipuliert und/oder gegebenfalls gedreht werden, wobei das Risiko einer Beschädigung der Solarzellen, der Lötbändchen und/oder der Lötstellen nicht unerheblich ist.

Darüber hinaus werden auch Verfahren beschrieben, bei denen Solarzellen beziehungsweise Solarzelltypen verbunden werden, welche bevorzugt sämtliche Kontakte auf der Rückseite aufweisen und keine Kontaktierung der Vorderseite erfordern. Dabei können zum Beispiel spezielle PUM- (Pin-up module), MWT-(Metal wrap through), EWT-Solarzellen (Emitter wrap through) oder IBC-Solarzellen (Integrated Back Circuit) zur Herstellung von Solarmodulen verwendet werden, die sämtliche Kontakte auf der Rückseite aufweisen und keine Kontaktierung der Vorderseite erfordern. Dadurch können einzelne Solarzellen statt durch Lötbändchen über eine metallische Verbindungsfolie, die rückseitig aufgebracht wird und durch ihre Gestaltung eine geeignete Verschaltung der Solarzellen ermöglicht, miteinander verbunden werden. Die metallische Verbindungsfolie mit einer geeigneten Gestaltung weist dabei bevorzugt vorgesehene Plätze für die einzelnen Solarzellen eines geplanten Solarmoduls auf, sodass diese Solarzellen durch eine geeignete Verschaltung miteinander verbunden und zum Beispiel reihenweise in Serie geschaltet werden können.

Einzelne Solarzellen werden dabei mit ihren Kontakten lediglich am richtigen Platz und gegebenenfalls mit der richtigen Ausrichtung auf die Metallfolie gelegt und eventuell noch mit der metallischen Verbindungsfolie verbunden, zum Beispiel durch elektrisch leitenden Kleber oder durch ein entsprechendes Lot, um miteinander elektrisch verbunden und zum Beispiel reihenweise in Serie geschaltet zu werden. Dabei kann die metallische Verbindungsfolie im Modul mit einer EVA-Folie zwischen den Solarzellen und der Rückseitenabdeckung angeordnet werden.

Die dünne metallische Verbindungsfolie mit ihrer besonderen Gestaltung zum Verbinden von Solarzellen kann insbesondere zum Beispiel auf ein Trägermaterial aufgebracht sein und bevorzugt zum Beispiel mit einem fotolithografischen beziehungsweise mit einem lithografischen Verfahren und einer entsprechenden Masque aus einer Metallfolie geätzt werden.

Durch die Verwendung einer rückseitigen metallischen Verbindungsfolie statt der Lötbändchen können die Manipulations- und/oder Drehschritte, die zur Herstellung der Solarzellstrings erforderlich sind, reduziert werden. Daher kann auch das Risiko einer Beschädigung beziehungsweise eines Fehlers im Modul reduziert werden.

Ein Nachteil bei der Verwendung einer rückseitigen metallischen Verbindungsfolie mit einer besondere Gestaltung zur Verbindung der Solarzellen ist jedoch, dass die Folie und insbesondere die Gestaltung der Folie jeweils an die Position der Kontakte auf der Rückseite der Solarzellen in Abhängigkeit des verwendeten Solarzelltyps angepasst werden muss.

Darüber hinaus muss die metallische Verbindungsfolie und insbesondere deren Gestaltung zudem umständlich an die Form und Größe des jeweils gewünschten Moduls angepasst werden. Unterschiedliche Modulgrößen und Modulformen benötigen zu unterschiedlich gestaltete metallische Verbindungsfolien. Die Anzahl der vorgesehenen Plätze für Solarzellen und deren Anordnung muss dabei entsprechend in Abhängigkeit der Größe und der Form des jeweils gewünschten Moduls gegebenenfalls angepasst werden.

Bei der Fertigung von Modulen in verschiedenen Formen und Größen kann dabei relativ schnell ein großer Anpassungsaufwand entstehen.

Angesichts des Standes der Technik besteht daher der Bedarf an einem Verfahren zur Herstellung eines Solarmoduls, bei dem das Risiko einer Beschädigung der Solarzellen oder der Verbindungen der einzelnen Solarzellen durch eine Vielzahl von Arbeitsschritten, insbesondere zum Beispiel von Manipulations- und Transportschritten zum Verbinden der einzelnen Solarzellen, möglichst reduziert wird und wobei gleichzeitig jedoch eine große Flexibilität bezüglich des verwendeten Solarzellentyps und/oder der Form und/oder Größe des hergestellten Solarmoduls gewährleistet bleibt.

Es ist daher die Aufgabe der vorliegenden Erfindung, ein solches Verfahren zur Verfügung zu stellen.

Dies wird durch ein Verfahren zum Herstellen eines Solarmoduls mit den Merkmalen des Anspruchs 1 erreicht.

Weitere vorteilhafte Ausführungsformen des erfindungsgemäßen Verfahrens ergeben sich aus der Beschreibung und den Unteransprüchen.

Die vorliegende Erfindung betrifft ein Verfahren zur Herstellung eines Solarmoduls, bei dem ein elektrisch leitendes Verbindungsmotiv auf ein Substrat und insbesondere ein Substrat aus Glas aufgebracht wird, sodass Solarzellen auf dem Substrat, welches das Verbindungsmotiv umfasst, angeordnet werden können, wobei die Rückkontakte von mindestens zwei Solarzellen elektrisch leitend mit dem Verbindungsmotiv verbunden werden können, um eine Verschaltung der Solarzellen zu ermöglichen, wobei ferner eine Glasscheibe mit dem Substrat, welches das Verbindungsmotiv umfasst, und den darauf angeordneten Solarzellen vereinigt wird.

Eine Verschaltung von mindestens zwei Solarzellen kann zum Beispiel insbesondere dann ermöglicht werden, wenn diese Solarzellen elektrisch miteinander verbunden werden und insbesondere zum Beispiel parallel und/oder in Serie geschaltet werden. Verbinden/Verschalten kann zum Beispiel insbesondere elektrisch miteinander verbinden beziehungsweise insbesondere zum Beispiel parallel und/oder in Serie schalten bedeuten. In Serie geschaltet können mindestens zwei Solarzellen dabei zum Beispiel werden, wenn der Pluspol und/oder der Minuspol einer Solarzelle respektive mit dem Minuspol und/oder dem Pluspol einer weiteren Solarzelle verbunden ist. Parallel geschaltet können mindestens zwei Solarzellen dabei zum Beispiel werden, wenn der Pluspol und/oder der Minuspol einer Solarzelle respektive mit dem Pluspol und/oder dem Minuspol einer weiteren Solarzelle verbunden ist.

In einer Ausführungsform des erfindungsgemäßen Verfahrens zur Herstellung eines Solarmoduls kann ein elektrisch leitendes Verbindungsmotiv bevorzugt haftend auf ein Substrat aufgebracht werden. Dabei kann das Substrat daher mitsamt dem haftend aufgebrachten Verbindungsmotiv ein eigenes und manipulierbares Teil darstellen. Das Substrat mit dem haftend aufgebrachten Verbindungsmotiv kann dadurch gleichzeitig sowohl zum Verbinden/Verschalten der Solarzellen des Moduls als auch als Rückseitenabdeckung für ein Modul verwendete werden. Dadurch kann die Herstellung der Solarmodule vereinfacht werden, da die Rückseitenabdeckung und eine Verbindungsfolie nicht separat transportiert, gelagert, manipuliert und eingebaut werden müssen.

In einer Ausführungsform des erfindungsgemäßen Verfahrens zur Herstellung eines Solarmoduls kann das elektrisch leitende Verbindungsmotiv mindestens elektrisch leitendes Material und insbesondere zum Beispiel mindestens ein Metall und/oder mindestens eine Metalllegierung und/oder Kohlenstoff umfassen. Dadurch kann eine ausreichende elektrische Leitfähigkeit erreicht und elektrischer Strom ausreichend gut abgeleitet werden. Dabei kann das elektrisch leitende Verbindungsmotiv insbesondere zum Beispiel Gold, Silber, Kupfer, Aluminium, Nickel, Chrom, Zinn, Zink, Blei, Eisen und/oder mindestens eine Metalllegierung, insbesondere zum Beispiel mindestens eine Metalllegierung, die mindestens eines der vorgenannten Metalle umfasst, beziehungsweise insbesondere eine Metalllegierung, wie zum Beispiel Stahl, Edelstahl oder Messing umfassen, um eine ausreichende elektrische Leitfähigkeit zu erreichen und den elektrischen Strom ausreichend gut abzuleiten. In einer Ausführungsform des erfindungsgemäßen Verfahrens zur Herstellung eines Solarmoduls kann das elektrisch leitende Verbindungsmotiv zusätzlich oder alternativ dazu auch Kohlenstoff umfassen, um eine ausreichende elektrische Leitfähigkeit zu erreichen und den elektrischen Strom ausreichend gut abzuleiten.

In einer Ausführungsform des erfindungsgemäßen Verfahrens zur Herstellung eines Solarmoduls kann das elektrisch leitende Verbindungsmotiv bevorzugt zum Beispiel eine Dicke von 0,5 µm bis 5000 µm, bevorzugt eine Dicke von 1 µm bis 1000 µm, weiter bevorzugt eine Dicke von 10 µm bis 500 µm, weiter bevorzugt eine Dicke von 50 µm bis 250 µm, besonders bevorzugt eine Dicke von 100 µm bis 200 µm, aufweisen. Bei dem angegebenen beispielhaften Werten handelt es sich bevorzugt zum Beispiel um Werte für die lokale Dicke an einem bestimmten Punkt des Verbindungsmotivs. Die Dicke des Verbindungsmotivs kann jedoch variieren, um Verdickungen und/oder Verdünnungen des Verbindungsmotivs zu ermöglichen.Dabei kann die Dicke des elektrisch leitenden Verbindungsmotivs dazu beitragen eine ausreichende elektrische Leitfähigkeit zu erreichen, um den elektrischen Strom ausreichend gut abzuleiten. Eine größere Dicke des elektrisch leitenden Verbindungsmotivs erhöht dabei die elektrische Leitfähigkeit. Des Weiteren kann eine Dicke des Verbindungsmotivs, welche zum Beispiel größer/gleich 1µm sein kann, besonders bevorzugt werden. Dadurch kann insbesondere zum Beispiel die Widerstandsfähigkeit und die Leitfähigkeit des Verbindungsmotivs erhöht werden. Zudem kann dadurch gegebenenfalls zum Beispiel das Risiko einer Beschädigung des Verbindungsmotivs, insbesondere zum Beispiel durch Abrieb und/oder Abnutzung, und/oder das Risiko des Auftretens eines Fehlers innerhalb des Moduls und insbesondere des Verbindungsmotivs, zum Beispiel durch eine Kontaktunterbrechung beziehungsweise eine Stromkreisunterbrechung und/oder einen Kurzschluss, reduziert werden.

In einer Ausführungsform des erfindungsgemäßen Verfahrens zur Herstellung eines Solarmoduls kann das elektrisch leitende Verbindungsmotiv zum Beispiel mindestens zwei und/oder bevorzugt mehr als zwei Schichten mindestens eines elektrisch leitenden Materials und insbesondere eines Metalls und/oder einer Metalllegierung und/oder Kohlenstoff umfassen. Mindestens zwei Schichten können dabei zum Beispiel insbesondere unterschiedliche elektrisch leitende Materialien umfassen beziehungsweise aus unterschiedlichen elektrisch leitenden Materialien bestehen. Dabei können einzelne Schichten insbesondere zum Beispiel zumindest teilweise dazu beitragen, unterschiedliche Zwecke, wie zum Beispiel insbesondere die Verbesserung der Haftung auf dem Substrat und/oder die Verbesserung der Leitfähigkeit und/oder die Verbesserung des elektrischen Kontakts mit einer auf das Verbindungsmotiv aufgebrachten Solzelle und/oder die Verbesserung der Haftung von Lot auf dem Verbindungsmotivs und/oder die Verbesserung des Korrosionsschutzes, zu erfüllen.

Die elektrische Leitfähigkeit kann dabei insbesondere zum Beispiel durch das verwendete elektrisch leitende Material und/oder durch den Querschnitt dieses Material beeinflusst werden. Demnach kann die elektrische Leitfähigkeit insbesondere zum Beispiel auch jeweils durch die Dicke und/oder die Breite des elektrisch leitenden Verbindungsmotivs beeinflusst werden, da diese den Querschnitt des elektrisch leitenden Materials beeinflussen. Die lokale elektrische Leitfähigkeit an jedem Punkt des elektrisch leitenden Verbindungsmotivs kann daher zum Beispiel auch jeweils durch die lokale Dicke und/oder die lokale Breite des leitende Verbindungsmotivs an einem Punkt beeinflusst werden, da diese den lokalen Querschnitt des elektrisch leitenden Materials beeinflussen.

In einer Ausführungsform des erfindungsgemäßen Verfahrens zur Herstellung eines Solarmoduls kann das elektrisch leitende Verbindungsmotiv bevorzugt zum Beispiel eine Breite von 0,0001 mm bis 2000 mm, bevorzugt eine Breite von 0,01 mm bis 500 mm, weiter bevorzugt eine Breite von 0,1 mm bis 250 mm, weiter bevorzugt eine Breite von 1 mm bis 200 mm, weiter bevorzugt eine Breite von 5 mm bis 70 mm, weiter bevorzugt eine Breite von 10 mm bis 70 mm, besonders bevorzugt eine Breite von 20 mm bis 40 mm, aufweisen. Bei dem angegebenen beispielhaften Werten handelt es sich bevorzugt zum Beispiel um Werte für die lokale Breite an einem bestimmten Punkt des Verbindungsmotivs. Die Breite des Verbindungsmotivs kann jedoch variieren, um Verbreiterungen und/oder Verengungen des Verbindungsmotivs zu ermöglichen. Dabei kann die Breite des elektrisch leitenden Verbindungsmotivs dazu beitragen eine ausreichende elektrische Leitfähigkeit zu erreichen, um den elektrischen Strom ausreichend gut abzuleiten. Eine größere Breite des elektrisch leitenden Verbindungsmotivs erhöht dabei die elektrische Leitfähigkeit.

Eine ausreichende elektrische Leitfähigkeit kann zum Beispiel eine elektrische Leitfähigkeit sein, die es ermöglicht, dass die Parameter des hergestellten Moduls nicht unzulässig variieren. Elektrischer Strom kann dabei gleichfalls insbesondere zum Beispiel ausreichend gut abgeleitet werden, wenn die elektrischen Parameter des hergestellten Moduls nicht unzulässig variieren. Eine ausreichende elektrische Leitfähigkeit kann dabei zum Beispiel eine elektrische Leitfähigkeit von 0,05 S/m bis 1×10¹⁰ S/m, bevorzugt eine elektrische Leitfähigkeit von 1 S/m bis 1×10⁹ S/m weiter bevorzugt eine elektrische Leitfähigkeit von 1 ×10⁴ S/m bis 1 ×10⁸ S/m, weiter bevorzugt eine elektrische Leitfähigkeit von 1 ×10⁶ S/m bis 1×10⁷ S/m, elektrische Leitfähigkeit von 9×10⁶ S/m bis 63×10⁶ S/m, besonders bevorzugt eine elektrische Leitfähigkeit von 16×10⁶ S/m bis 37×10⁶ S/m, darstellen. Bei dem angegebenen beispielhaften Werten handelt es sich bevorzugt zum Beispiel um Werte für die lokale Leitfähigkeit an einem bestimmten Punkt des Verbindungsmotivs. Die Leitfähigkeit des Verbindungsmotivs kann jedoch variieren.

In einer Ausführungsform des erfindungsgemäßen Verfahrens zur Herstellung eines Solarmoduls kann das Substrat auf welches das elektrisch leitende Verbindungsmotiv aufgebracht wird ein Glassubstrat beziehungsweise eine weitere Glasscheibe sein. In einer Ausführungsform des erfindungsgemäßen Verfahrens zur Herstellung eines Solarmoduls kann das elektrisch leitende Verbindungsmotiv demnach zum Beispiel direkt auf ein Glassubstrat beziehungsweise auf einer weiteren Glasscheibe aufgebracht werden. Dies kann insbesondere bei der Herstellung von sogenannten Glas-Glas-Solarmodulen wünschenswert sein, da die verwendete Rückenabdeckung bei solchen Modulen ein Glassubstrat beziehungsweise eine weitere Glasscheibe ist. In der Tat sind die Solarzellen bei solchen Glas-Glas-Solarmodulen zwischen zwei Glasscheiben angeordnet beziehungsweise eingebettet. Dadurch, dass das elektrisch leitende Verbindungsmotiv zum Beispiel direkt auf ein Glassubstrat aufgebracht werden kann, kann bei der Herstellung von Glas-Glas-Solarmodulen die Verbindung/Verschaltung der einzelnen Solarzellen durch ein Glassubstrat beziehungsweise eine weitere Glasscheibe mit einem bevorzugt haftend aufgebrachten Verbindungsmotiv, welches gleichzeitig die Rückseitige Abdeckung darstellen kann, ermöglicht werden. Das Glassubstrat beziehungsweise die weitere Glasscheibe mit dem haftend aufgebrachten Verbindungsmotiv kann dadurch gleichzeitig sowohl zum Verbinden/Verschalten der Solarzellen des Moduls als auch als Rückseitenabdeckung für ein Modul verwendet werden. Dadurch kann die Herstellung von Glas-Glas Solarmodulen vereinfacht werden, da die Rückseitenabdeckung und eine Verbindungsfolie nicht separat transportiert, gelagert, manipuliert und eingebaut werden müssen.

In einer Ausführungsform des erfindungsgemäßen Verfahrens zur Herstellung eines Solarmoduls kann das elektrisch leitende Verbindungsmotiv zum Beispiel so gestaltet sein, dass die Gestaltung des Verbindungsmotivs mindestens zwei darauf platzierte und/oder bevorzugt damit verbundene Solarzellen in Serie und/oder parallel schalten kann. Eine elektrische Verbindung zwischen den Solarzellen und dem Verbindungsmotiv kann dabei bereits durch bloßen Kontakt zwischen dem Verbindungsmotiv und den darauf platzierten und aufliegenden Solarzellen hergestellt werden kann. Zudem können die Solarzellen gegebenenfalls jedoch noch zusätzlich elektrisch mit dem Verbindungsmotiv und insbesondere mit den Kontaktzonen verbunden werden, zum Beispiel durch löten mit einem entsprechenden Lot und/oder durch elektrisch leitend Kleben. Die Gestaltung des Verbindungsmotivs kann dabei insbesondere zum Beispiel das Muster beziehungsweise die Form des elektrisch leitenden Verbindungsmotivs darstellen. Dabei kann die Gestaltung des Verbindungsmotivs vorgesehene Kotaktzonen zum Kontaktieren der Rückkontakte von Solarzellen umfassen. Kontaktieren kann dabei insbesondere zum Beispiel elektrisch leitend verbinden und bevorzugt zum Beispiel elektrisch leitend verbinden durch bloßen Kontakt verbinden bedeuten. Ein elektrischer Kontakt zwischen den Solarzellen und dem Verbindungsmotiv kann dabei gegebenenfalls bereits bei beziehungsweise nach dem Platzieren der Solarzellen auf dem Verbindungsmotiv und insbesondere auf den Kontaktzonen des Verbindungsmotivs durch bloßen Kontakt zwischen dem Verbindungsmotiv und den aufliegenden Solarzellen hergestellt werden. Eine Kontaktzone kann dabei zum Beispiel ein Bereich und insbesondere ein zusammenhängender Bereich des Verbindungsmotivs sein, welcher zum Kontaktieren eines Pols einer Solarzelle vorgesehen sein kann. Das Verbindungsmotiv kann dabei mehrere Kontaktzone beziehungsweise Bereiche umfassen, die bevorzugt durch die Gestaltung des Verbindungsmotivs elektrisch miteinander verbunden sein können. Die Kontaktzonen beziehungsweise Bereiche des Verbindungsmotivs können dabei bevorzugt zum Beispiel so durch die Gestaltung des Verbindungsmotivs elektrisch miteinander verbunden sein, dass die auf das Verbindungsmotiv platzierten Solarzellen bevorzugt bei entsprechender Ausrichtung miteinander verschaltet werden können und bevorzugt zum Beispiel gruppenweise sowie insbesondere spaltenweise oder reihenweise parallel oder bevorzugt in Serie geschaltet werden können. Die Solarzellen können dabei zum Verschalten bevorzugt zum Beispiel lediglich auf das Verbindungsmotiv und insbesondere auf die entsprechenden Kontaktzonen bevorzugt mit der entsprechenden Ausrichtung gelegt beziehungsweise platziert werden, um gegebenenfalls eine Verschaltung der Solarzellen zu erreichen, wobei eine elektrische Verbindung zwischen den Solarzellen und dem Verbindungsmotiv bereits durch bloßen Kontakt zwischen den aufliegenden Solarzellen und dem Verbindungsmotiv hergestellt werden kann. Zudem können die Solarzellen gegebenenfalls jedoch noch zusätzlich elektrisch mit dem Verbindungsmotiv und insbesondere mit den Kontaktzonen verbunden werden, zum Beispiel durch Löten mit einem entsprechenden Lot und/oder durch elektrisch leitend Kleben. Darüber hinaus können die einzelnen Gruppen und/oder Spalten und/oder Reihen von Solarzellen, die durch das Verbindungsmotiv verschaltet werden können, durch die Gestaltung des Verbindungsmotivs ebenfalls in Serie insbesondere parallel geschaltet werden, um zum Beispiel bestimmte Spannung- oder Leistungsparameter erreichen zu können. Dabei kann das Verbindungsmotiv zum Beispiel mindestens zwei bevorzugt durch die Gestaltung des Verbindungsmotivs in Serie und/oder parallel geschaltete Kontaktzonen aufweisen, wobei bevorzugt zum Beispiel mindestens eine Kontaktzone, die einen Minuspol oder einen Pluspol darstellen kann, durch das Verbindungsmotiv und insbesondere die Gestaltung des Verbindungsmotivs respektive mit mindestens einer Kontaktzone, die einen Minuspol oder einen Pluspol darstellen kann, oder mit mindestens einer Kontaktzone, die einen Pluspol oder einen Minuspol darstellen kann, verbunden werden kann, damit die Gestaltung des Verbindungsmotivs zum Beispiel mindestens zwei zumindest teilweise auf den jeweiligen Kontaktzonen platzierte und/oder bevorzugt zumindest teilweise damit verbundene Solarzellen zum Beispiel respektive in Serie und/oder parallel schalten kann. Eine Kontaktzone, die einen Minuspol oder einen Pluspol darstellen kann, kann dabei insbesondere zum Beispiel eine Kontaktzone des Verbindungsmotivs sein, die mit einem Minuspol oder einem Pluspol einer Solarzelle elektrisch verbunden sein kann beziehungsweise elektrisch verbunden ist und/oder eine Kontaktzone sein, die durch Verbindung von mindestens zwei Solarzellen durch das Verbindungsmotiv zum Minuspol oder zum Pluspol einer Gruppe von Solarzellen, die zum Beispiel durch das Verbindungsmotiv parallel und/oder in Serie geschaltet sein können, werden kann beziehungsweise wird. Die Solarzellen können dabei zum elektrischen Kontaktieren mit dem Verbindungsmotiv zum Beispiel auf das Verbindungsmotiv und insbesondere auf die Kontaktzonen gelegt beziehungsweise platziert werden und zudem jedoch gegebenenfalls auch noch zusätzlich elektrisch damit verbunden werden, zum Beispiel durch Löten mit einem entsprechenden Lot und/oder durch elektrisch leitend Kleben. In einer Ausführungsform des erfindungsgemäßen Verfahrens zur Herstellung eines Solarmoduls können die Solarzellen demnach zum Beispiel durch elektrisch leitend Kleben und/oder Löten insbesondere zum Beispiel Laserlöten und/oder Ultraschalllöten und/oder Reibschweißen und/oder unter Verwendung eines Lots elektrisch durch andere Verbindungstechniken mit dem Verbindungsmotiv verbunden werden. Dabei können Lote insbesondere niedrig schmelzende Lote und/oder elektrische leitende Kleber, wie zum Beispiel Silberpaste oder Silberlack beziehungsweise Grafitpaste und/oder Grafitlack und/oder entsprechende Harze, verwendet werden, um die Solarzellen und das Verbindungsmotiv elektrisch miteinander zu verbinden. Dadurch kann gegebenenfalls eine bessere und widerstandsfähigere beziehungsweise belastbarere elektrische Verbindung zwischen Solarzellen und Verbindungsmotiv als durch bloßen Kontakt ermöglicht werden.

In einer Ausführungsform des erfindungsgemäßen Verfahrens zur Herstellung eines Solarmoduls können die Solarzellen und insbesondere deren Kontakte gegebenenfalls zum Beispiel auch über zusätzliche elektrisch leitende Kontaktelemente und insbesondere zum Beispiel über elektrisch leitende federnde Kontaktelemente mit dem Verbindungsmotiv elektrisch verbunden werden. Die zusätzlichen Kontaktelemente und insbesondere die zusätzlichen elektrisch leitenden federnden Kontaktelemente können dabei zum Beispiel zwischen dem Substrat mit den Verbindungsmotiv und den Solarzellen angeordnet und gegebenenfalls elektrisch mit den Solarzellen beziehungsweise mit deren Kontakte und/oder mit dem Verbindungsmotiv beziehungsweise dessen Kontaktzonen verbunden werden.

Die Ausrichtung der Solarzellen und ihrer Kontakte kann dabei zum Beispiel die Orientierung der Solarzellen und ihrer Kontakte darstellen. Das Ausrichten der Solarzellen und ihrer Kontakte kann dabei zum Beispiel die Änderung der Orientierung der Solarzellen und ihrer Kontakte darstellen. Das Ausrichten der Solarzellen kann dabei insbesondere zum Beispiel vor dem Platzieren der Solarzellen auf dem Substrat mit dem Verbindungsmotiv erfolgen. Das Ausrichten einer Solarzelle kann zum Beispiel durch eine Drehung der Solarzelle um eine bevorzugt vertikale Achse erfolgen. Die Solarzellen können dabei bevorzugt zum Beispiel jeweils so ausgerichtet werden, dass ihre Kontakte nach dem Platzieren der Solarzellen auf dem Substrat mit dem Verbindungsmotiv zumindest teilweise auf den entsprechenden Kontaktzonen des Verbindungsmotivs ruhen können. Mehrere Kontakte/Kontaktpunkte können dabei zum Beispiel den Pluspol und/oder den Minuspol einer Solarzelle bilden, welcher/welche gegebenenfalls bei entsprechender Ausrichtung auf entsprechenden Kontaktzonen des Verbindungsmotivs ruhen können. Die Ausrichtung der Solarzellen kann so gewählt werden, dass die gewünschte Verschaltung der Solarzellen durch das Verbindungsmotiv ermöglich wird. Die jeweiligen Kontaktzonen des Verbindungsmotivs können dabei durch die Gestaltung des Verbindungsmotivs so miteinander verbunden sein, dass mindestens zwei bevorzugt mit der richtigen Ausrichtung mit ihren Rückkontakten darauf platzierte und/oder damit elektrisch verbundene Solarzellen parallel und/oder in Serie geschaltet werden. Die Kontaktzonen des Verbindungsmotivs können dabei bevorzugt zum Beispiel so vorgesehen sein, dass zum Beispiel jeweils mindestens eine Kontaktzone zum Kontaktieren mindestens eines Teils des Minuspols einer Solarzelle und/oder mindestens eine Kontaktzone zum Kontaktieren mindestens eines Teils des Pluspols einer Solarzelle vorgesehen ist. Die Form der jeweiligen Kontaktzonen des Verbindungsmotivs kann dabei bevorzugt zum Bespiel an die jeweilige Anordnung der Rückkontakte des verwendeten Solarzelltyps angepasst werden, sodass zum Beispiel jeweils mindestens eine Kontaktzone zum Kontaktieren mindestens eines Teils des Minuspols einer Solarzelle und/oder mindestens eine Kontaktzone zum Kontaktieren mindestens eines Teils des Pluspols einer Solarzelle dienen kann. Die Rückkontakte können dabei zum Beispiel jeweils einen Pluspol und/oder einen Minuspol umfassen, die jeweils wiederum mehrere Kontaktpunkte umfassen können. Diese Kontaktpunkte können dabei an unterschiedlichen Stellen und bevorzugt jeweils voneinander getrennt an der Rückseite der Solarzellen vorgesehen sein. "Voneinander getrennt" kann dabei zum Beispiel insbesondere bedeuten, dass sie auf Distanz zueinander und ohne Kontakt insbesondere ohne elektrischen Kontakt angeordnet sind. Dabei kann insbesondere zum Beispiel die Anzahl und/oder Größe und/oder Form und/oder Anordnung der Kontaktpunkte je nach dem verwendeten Solarzelltyp variieren. Dabei stellt ein bestimmter Teil der vorgesehenen Kontaktpunkte den Minuspol der Solarzelle dar. Ein anderer Teil der vorgesehenen Kontaktpunkte kann dabei den Pluspol der Solarzelle darstellen. Die Kontaktpunkte die den Minuspol einer Solarzelle darstellen können zunächst mit dem Verbindungsmotiv und insbesondere mit einer Kontaktzone des elektrisch leitenden Verbindungsmotivs elektrisch leitend verbunden werden und durch die Gestaltung des Verbindungsmotivs bevorzugt zum Beispiel auch jeweils miteinander verbunden werden. Gleichfalls können die Kontaktpunkte, die den Pluspol einer Solarzelle darstellen, ebenfalls zunächst mit dem Verbindungsmotiv und insbesondere mit einer Kontaktzone des elektrisch leitenden Verbindungsmotivs elektrisch verbunden werden und durch die Gestaltung des Verbindungsmotivs bevorzugt zum Beispiel auch jeweils miteinander verbunden werden. Die Kontaktpunkte des Pluspols und/oder des Minuspols einer Solarzelle, die mit dem Verbindungsmotiv und insbesondere mit einer Kontaktzone des Verbindungsmotivs elektrisch verbunden ist, können dabei durch die Gestaltung des Verbindungsmotivs mit den Kontaktpunkten des Pluspols und/oder des Minuspols mindestens einer weiteren Solarzelle, die mit dem Verbindungsmotiv und insbesondere mit einer weiteren anderen Kontaktzone des Verbindungsmotivs elektrisch verbunden ist, elektrisch verbunden werden, um die Solarzellen zu verbinden/verschalten und insbesondere zum Beispiel parallel und/oder in Serie zu schalten. Des Weiteren kann das Verbindungsmotiv gegebenenfalls zum Beispiel auch mindestens einen Anschlusskontakt beziehungsweise eine Anschlussfläche bevorzugt jedoch zum Beispiel zwei Anschlusskontakte beziehungsweise zwei Anschlussflächen zum Anschließen mindestens einer Bypass-Diode und/oder mindestens eines Verbindungssystems beziehungsweise Verbindungsmittels bevorzugt jedoch zum Anschließen von zwei Verbindungssystemen beziehungsweise zwei Verbindungsmitteln, die zum Verbinden von mindestens zwei Modulen dienen können, umfassen. Dabei können durch die Gestaltung des Verbindungsmotivs mindestens zwei Gruppen von jeweils mindestens zwei in Serie geschalteten elektrisch verbundenen Solarzellen so parallel geschaltet sein, dass der Pluspol und/oder der Minuspol jeder Gruppe beziehungsweise die Kontaktzone(n) des Verbindungsmotivs, die den Pluspol und/oder den Minuspol jeder in Serie geschalteten Gruppe darstellen können, durch das Verbindungsmotiv und insbesondere durch die Gestaltung des Verbindungsmotivs respektive mit einem Anschlusskontakt beziehungsweise einer Anschlussfläche elektrisch verbunden sein kann, die respektive den Pluspol oder den Minuspol des Moduls darstellen kann. Darüber hinaus kann die Gestaltung des Verbindungsmotivs für jede Gruppe von jeweils mindestens zwei durch das Verbindungsmotiv in Serie geschalteten elektrisch verbundenen Solarzellen jeweils mindestens einen Anschlusskontakt beziehungsweise eine Anschlussfläche, bevorzugt jedoch zum Beispiel zwei Anschlusskontakte beziehungsweise zwei Anschlussflächen zum Anschließen mindestens einer Bypass-Diode vorsehen, sodass der Pluspol und/oder der Minuspol jeder in Serie geschalteten Gruppe beziehungsweise die Kontaktzone(n) des Verbindungsmotivs, die den Pluspol und/oder den Minuspol jeder in Serie geschalteten Gruppe darstellen können, durch das Verbindungsmotiv und insbesondere durch die Gestaltung des Verbindungsmotivs respektive mit einem Anschlusskontakt beziehungsweise einer Anschlussfläche elektrisch verbunden sein kann/können. Dabei kann jede Gruppe von jeweils mindestens zwei durch das Verbindungsmotiv in Serie geschalteten elektrisch verbundenen Solarzellen über einen Anschlusskontakt beziehungsweise eine Anschlussfläche, bevorzugt jedoch zum Beispiel zwei Anschlusskontakte beziehungsweise zwei Anschlussflächen mit mindestens einer Bypass-Diode bevorzugt zum Beispiel parallel geschaltet werden, um den Strom gegebenenfalls an mindestens einer in Serie geschalteten Gruppe vorbeizuleiten.

Dabei können Solarzellen einer Ausführungsform des erfindungsgemäßen Verfahrens zur Herstellung eines Solarmoduls auf das Substrat mit dem elektrisch leitenden Verbindungsmotiv platziert werden. In einer besonderen Ausführungsform des erfindungsgemäßen Verfahrens zur Herstellung eines Solarmoduls kann zum Beispiel mindestens eine Polymerfolie und bevorzugt genau eine Polymerfolie, insbesondere zum Beispiel eine EVA-Folie, auf dem Substrat mit dem elektrisch leitenden Verbindungsmotiv und somit zwischen dem Substrat und den gegebenenfalls auf der Polymerfolie und insbesondere zum Beispiel der EVA-Folie platzierten Solarzellen angeordnet werden. Eine Polymerfolie kann dabei zum Beispiel eine Folie sein, welche EVA, PVB, mindestens ein Silicon, mindestens ein Polyolefin, mindestens ein Polyester, mindestens ein Acrylat und/oder Methacrylat, mindestens ein lonomer und/oder mindestens eine Mischung oder ein Copolymer dieser Stoffe umfasst. Sofern eine Polymerfolie beziehungsweise zum Beispiel eine EVA-Folie verwendet und zwischen dem Substrat mit dem Verbindungsmotiv und den Solarzellen angeordnet beziehungsweise gelegt wird, kann die Polymerfolie beziehungsweise die EVA-Folie zum Beispiel Aussparungen aufweisen, um die Rückkontakte der Solarzellen mit dem Verbindungsmotiv elektrisch verbinden zu können. Alternativ oder zusätzlich zu einer Polymerfolie beziehungsweise zu einer zum Beispiel verwendeten EVA-Folie, welche zwischen Substrat und Solarzellen angeordnet ist, kann eine weitere Polymerfolie beziehungsweise zum Beispiel auch eine EVA-Folie auch über die Solarzellen gelegt beziehungsweise angeordnet werden.

Darüber hinaus kann im erfindungsgemäßen Verfahren zur Herstellung eines Solarmoduls eine Glasscheibe auf den Solarzellen beziehungsweise auf der darüber angeordneten/gelegten Polymerfolie beziehungsweise zum Beispiel verwendeten EVA-Folie angeordnet werden. Anschließend kann eine Glasscheibe mit dem Substrat, welches das Verbindungsmotiv umfasst, und den darauf angeordneten Solarzellen vereinigt werden. Eine Polymerfolie beziehungsweise insbesondere zum Beispiel eine EVA-Folie kann demnach insbesondere zum Beispiel zwischen dem Substrat und den Solarzellen und/oder zwischen den Solarzellen und der Glasscheibe angeordnet werden. Mindestens eine Polymerfolie und insbesondere zum Beispiel eine EVA-Folie können dabei dazu dienen, das Substrat, die Glasscheibe und die Solarzellen zu vereinigen beziehungsweise zu verbinden, insbesondere zum Beispiel unter Wärmeeinwirkung und/oder durch Ausübung von Druck, um ein Solarmodul herzustellen. Alternativ dazu kann zum Beispiel auch ein Harz verwendet werden, um das Substrat, die Glasscheibe und die Solarzellen zu vereinigen beziehungsweise zu verbinden.

Vereinigt/vereinigen kann dabei zum Beispiel verbunden/verbinden beziehungsweise zusammengeführt/zusammenführen insbesondere zu einer Einheit verbunden/verbinden beziehungsweise zu einer Einheit zusammengeführt/zusammenführen bedeuten. Eine Glasscheibe kann dabei mit dem Substrat, welches das Verbindungsmotiv umfasst, und den darauf angeordneten Solarzellen zum Beispiel durch Laminieren, insbesondere durch Ausübung von Druck und/oder bei Unterdruck und/oder unter Wärmeeinwirkung, vereinigt werden.

In einer Ausführungsform des erfindungsgemäßen Verfahrens zur Herstellung eines Solarmoduls kann Substrat, Polymerfolie(n) und insbesondere EVA-Folie(n), Solarzellen und Glasscheibe zum Beispiel durch Laminieren, insbesondere durch Ausübung von Druck und/oder bei Unterdruck und/oder unter Wärmeeinwirkung, vereinigt und insbesondere miteinander zu einem Solarmodul vereinigt/verbunden werden.

In einer Ausführungsform des erfindungsgemäßen Verfahrens zur Herstellung eines Solarmoduls kann das elektrisch leitende Verbindungsmotiv insbesondere zum Beispiel dank eines Sprüh- und/oder Spritzverfahren aufgebracht werden. Ein solches Verfahren ermöglicht es, das Verbindungsmotiv bequem und schnell aufzubringen. Insbesondere zum Beispiel die Gestaltung und/oder die Größe und/oder die jeweilige Dicke und/oder Breite und/oder die jeweilige lokale Dicke und/oder lokale Breite des Verbindungsmotivs kann dabei zum Beispiel an die gewünschte Modulgröße und/oder Modulform und/oder an den verwendeten Solarzelltyps beziehungsweise an dessen Kontaktanordnung besonders flexibel variiert beziehungsweise angepasst werden. Zudem können durch solche Verfahren auch dickere Schichten mindestens eines elektrisch leitenden Materials, insbesondere zum Beispiel Schichten mit einer Dicke größer/gleich 1µm, mit einer sehr guten Haftung auf ein Substrat aufgebracht werden. Das Aufbringen dickerer haftender Schichten ermöglicht es dabei zum Beispiel die Widerstandsfähigkeit des Verbindungsmotivs und/oder die elektrische Leitfähigkeit des Verbindungsmotivs beziehungsweise die Dicke des Verbindungsmotivs zu erhöhen. Dadurch kann das Risiko einer Beschädigung des Verbindungsmotivs, insbesondere zum Beispiel durch Abrieb und/oder Abnutzung, und/oder das Risiko des Auftretens eines Fehlers innerhalb des Moduls und insbesondere des Verbindungsmotivs zum Beispiel durch eine Kontaktunterbrechung beziehungsweise eine Stromkreisunterbrechung und/oder einen Kurzschluss, gegebenenfalls reduziert werden.

In einer Ausführungsform des erfindungsgemäßen Verfahrens zur Herstellung eines Solarmoduls kann das elektrisch leitende Verbindungsmotiv insbesondere zum Beispiel dank eines thermischen Spritzverfahrens insbesondere eines Flammspritzverfahrens und/oder dank eines Gasspritzverfahrens insbesondere eines Kaltgasspritzverfahrens aufgebracht werden. Bei thermischem Spritzen wird das Material zum Beispiel im zumindest teilweise geschmolzenen Zustand auf ein Substrat gesprüht. Bei einem Gasspritzverfahren werden Partikel eines Materials mit einem Gas beschleunigt und auf ein Substrat gesprüht. Dabei können die Partikel auf Überschallgeschwindigkeit oder insbesondere bei Verwendung von weicheren Substraten auch auf Unterschallgeschwindigkeit beschleunigt werden. Solche Verfahren ermöglichen es, das Verbindungsmotiv bequem und schnell auf einer Vielzahl von unterschiedlichen Substraten bevorzugt haftend aufzubringen. Insbesondere zum Beispiel die Gestaltung und/oder die Größe und/oder die Gestaltung und/oder die jeweilige Dicke und/oder Breite und/oder die jeweilige lokale Dicke und/oder lokale Breite des Verbindungsmotivs kann dabei zum Beispiel an die gewünschte Modulgröße und/oder Modulform und/oder an den verwendeten Solarzelltyps beziehungsweise an dessen Kontaktanordnung besonders flexibel angepasst werden.

In einer Ausführungsform des erfindungsgemäßen Verfahrens zur Herstellung eines Solarmoduls kann das elektrisch leitende Verbindungsmotiv mit und/oder ohne Kaschierung aufgebracht wird. Wenn ein thermisches Spritzverfahren und/oder insbesondere eine Flammspritzverfahren zum Aufbringen des elektrisch leitenden Verbindungsmotivs verwendet wird, kann eine größere Fläche auf einmal besprüht werden. Dabei kann eine Kaschierung verwendet werden, um eine größere Präzision und insbesondere präzise definierte Konturen des Verbindungsmotivs zu ermöglichen und/oder kleinere Details präzise zu gestalten. Wenn ein Gasspritzverfahren und/oder insbesondere ein Kaltgasspritzverfahren verwendet wird, um das elektrisch leitende Verbindungsmotiv aufzubringen, kann bevorzugt auch ohne Kaschierung eine große Präzision beim Aufbringen des elektrisch leitenden Verbindungsmotivs erreicht werden, da ein dabei verwendeter Strahl von Gas beschleunigten Partikeln, welcher auf das Substrat gesprüht wird, lediglich einen Durchmesser von einigen Millimeter aufweist. Dadurch kann das elektrisch leitende Verbindungsmotiv mit großer Präzision auf das Substrat bevorzugt ohne Kaschierung aufgebracht werden. Dabei können kleine Details und präzise Konturen beim Aufbringen und/oder bei Gestaltung des elektrisch leitenden Verbindungsmotivs ermöglicht werden. Um das Aufbringen des Verbindungsmotivs zu beschleunigen, können bei einem Gasspritzverfahren und/oder insbesondere einem Kaltgasspritzverfahren gegebenenfalls auch mehrere Partikelstrahlen zum Aufbringen des Verbindungsmotivs verwendet werden.

In einer Ausführungsform des erfindungsgemäßen Verfahrens zur Herstellung eines Solarmoduls kann das elektrisch leitende Verbindungsmotiv in Zeilen aufgeteilt werden. Die Unterteilung des elektrisch leitenden Verbindungsmotivs beziehungsweise der Gestaltung/Form des elektrisch leitenden Verbindungsmotivs in einzelne Zeilen kann dabei insbesondere zum Beispiel schon vor dem Aufbringen erfolgen. Dies kann insbesondere dann sinnvoll sein, wenn ein Gasspritzverfahren und/oder insbesondere ein Kaltgasspritzverfahren verwendet wird, um das elektrisch leitende Verbindungsmotiv auch ohne Kaschierung mit einer großen Präzision und mit mindestens einem Strahl mit einem Durchmesser von einigen Millimetern auf das Substrat aufzubringen, da die Unterteilung in mehrere Zeilen das Aufbringen des Verbindungsmotivs mit einem oder mehreren solcher Strahl(en) mit einem Durchmesser von einigen Millimetern erheblich vereinfachen kann. Die Breite der Zeilen kann dabei insbesondere zum Beispiel zumindest angenähert dem Durchmesser des/der verwendeten Partikelstrahls/ Partikelstrahlen entsprechen beziehungsweise zum Beispiel leicht zum Beispiel um 1 bis 50 %, bevorzugt um 5 bis 40 % kleiner sein. Dadurch kann das elektrisch leitende Verbindungsmotiv zum Beispiel entsprechend der gewünschten Gestaltung progressiv Zeile pro Zeile insbesondere zum Bespiel mit einem Gasspritzverfahren und/oder insbesondere ein Kaltgasspritzverfahren mit einem oder mehreren Partikelstrahl(en) aufgesprüht/aufgebracht werden. Dabei können benachbarte Zeilen zum Beispiel nacheinander aufgebracht werden. Durch das Aufteilen in Zeilen und/oder durch das Aufbringen Zeile für Zeile können auch größere Flächen des Verbindungsmotivs beziehungsweise der Gestaltung des Verbindungsmotivs ohne Kaschierung mit einem Gasspritzverfahren und/oder insbesondere einem Kaltgasspritzverfahren und mindestens einem Strahl mit einem Durchmesser von einigen Millimetern präzise, schnell und sehr bequem auf das Substrat aufgebracht werden.

In einer Ausführungsform des erfindungsgemäßen Verfahrens zur Herstellung eines Solarmoduls können benachbarte Zeilen des Verbindungsmotivs bevorzugt zum Beispiel jedoch auch nicht nacheinander aufgebracht werden. Dadurch kann zum Beispiel gegebenenfalls das Risiko einer Beschädigung des Substrats, zum Beispiel durch einen Temperaturanstieg und/oder durch die Bildung von Mikrorissen reduziert werden. In der Tat wird zum Beispiel, wenn ein Spritz- und/oder Sprühverfahren zum Aufbringen des Verbindungsmotivs verwendet wird, beim Auftreffen des aufgebrachten Materials auf das Substrat schnell kinetische Energie abgebaut. Dabei kann es zu einer Beschädigung des Substrats zum Beispiel durch einen Temperaturanstieg und/oder durch die Bildung von Mikrorissen kommen. Dadurch kann gegebenenfalls die Haftung und/oder die Materialresistenz reduziert werden. Zudem steigt das Risiko einer Beschädigung des Substrats an bestimmten Stellen, wenn an diesen Stellen länger Partikel aufgesprüht werden. Dies kann insbesondere zum Beispiel vorkommen, wenn größere Flächen, wie zum Beispiel insbesondere Kontaktzonen des Verbindungsmotivs, aufgebracht werden, da zum Aufbringen dieser größeren Flächen gegebenenfalls länger und/oder mehrfach an der gleichen Stelle oder im gleichen Bereich gesprüht/gespritzt wird. Dies kann insbesondere bei Verwendung eines Gasspritzverfahrens und/oder eines Kaltgasspritzverfahrens zum Aufbringen des elektrisch leitenden Verbindungsmotivs der Fall sein, da ein Partikelstrahl mit einem Durchmesser von wenigen Millimetern verwendet wird und dieser zum Aufbringen von größeren Flächen, wie zum Beispiel insbesondere Kontaktzonen des Verbindungsmotivs, gegebenenfalls länger und/oder mehrfach an der gleichen Stelle oder im gleichen Bereich geführt wird.

In einer Ausführungsform des erfindungsgemäßen Verfahrens zur Herstellung eines Solarmoduls kann das auf das Substrat aufgebrachte Verbindungsmotiv zum Beispiel nach dem Aufbringen auf das Substrat und/oder bevorzugt vor der Platzierung der Solarzellen und/oder der Anordnung der Polymerfolie(n) nachbearbeitet werden und insbesondere zum Beispiel durch Ätzen und/oder durch elektrochemische Abscheidung nachbearbeitet werden, um insbesondere zum Beispiel die Herstellung eines Verbindungsmotivs mit besonders feinen Details zu ermöglichen und/oder die Dicke des Verbindungsmotivs zu erhöhen und/oder mindestens eine weitere Metallschicht aufzubringen und/oder mindestens eine Metallschicht zumindest teilweise abzutragen.

Darüber hinaus betrifft die vorliegende Erfindung auch ein Solarmodul, welches ein Glassubstrat mit einem darauf haftend aufgebrachten Verbindungsmotiv umfasst.

In einer Ausführungsform des erfindungsgemäßen Solarmoduls kann das Verbindungsmotiv zum Beispiel so gestaltet sein, dass die Gestaltung des Verbindungsmotivs mindestens zwei darauf platzierte und/oder bevorzugt damit verbundene Solarzellen in Serie und/oder parallel schalten kann. In einer Ausführungsform des erfindungsgemäßen Solarmoduls kann dabei das Verbindungsmotiv mindestens zum Beispiel zwei bevorzugt durch die Gestaltung des Verbindungsmotivs in Serie und/oder parallel geschaltete Kontaktzonen aufweisen

In einer Ausführungsform des erfindungsgemäßen Solarmoduls kann das erfindungsgemäße Solarmodul nach einem erfindungsgemäßen Verfahren zur Herstellung eines Solarmoduls mit all seinen vorgenannten Merkmalen hergestellt werden.

Des Weiteren betrifft die vorliegende Erfindung, die Verwendung eines Glassubstrats mit einem darauf haftend aufgebrachten Verbindungsmotiv zum Herstellen eines Solarmoduls.

In einer Ausführungsform der erfindungsgemäßen Verwendung eines Glassubstrats mit einem darauf haftend aufgebrachten Verbindungsmotiv zum Herstellen eines Solarmoduls kann das Verbindungsmotiv zum Beispiel so gestaltet sein, dass die Gestaltung des Verbindungsmotivs mindestens zwei darauf platzierte und/oder bevorzugt damit verbundene Solarzellen in Serie und/oder parallel schalten kann. In einer Ausführungsform der erfindungsgemäßen Verwendung eines Glassubstrats mit einem darauf haftend aufgebrachten Verbindungsmotiv zum Herstellen eines Solarmoduls kann dabei das Verbindungsmotiv zum Beispiel mindestens zwei bevorzugt durch die Gestaltung des Verbindungsmotivs in Serie und/oder parallel geschaltete Kontaktzonen aufweisen.

In einer Ausführungsform der erfindungsgemäßen Verwendung eines Glassubstrats mit einem darauf haftend aufgebrachten Verbindungsmotiv zum Herstellen eines Solarmoduls kann das Solarmodul nach einem erfindungsgemäßen Verfahren zur Herstellung eines Solarmoduls mit all seinen vorgenannten Merkmalen hergestellt werden.

## Patentansprüche

1. Verfahren zur Herstellung eines Solarmoduls,
**dadurch gekennzeichnet,**
**dass** ein elektrisch leitendes Verbindungsmotiv auf ein Substrat aufgebracht wird, sodass Solarzellen auf dem Substrat, welches das Verbindungsmotiv umfasst, angeordnet werden, wobei die Rückkontakte von mindestens zwei Solarzellen elektrisch leitend mit dem Verbindungsmotiv verbunden werden können, um eine Verschaltung der Solarzellen zu ermöglichen, wobei ferner eine Glasscheibe mit dem Substrat, welches das Verbindungsmotiv umfasst, und den darauf angeordneten Solarzellen vereinigt wird.

2. Verfahren zur Herstellung eines Solarmoduls nach Anspruch 1,
**dadurch gekennzeichnet,**
**dass** das elektrisch leitende Verbindungsmotiv mindestens ein Metall beziehungsweise insbesondere Gold, Silber, Kupfer oder Aluminium umfasst.

3. Verfahren zur Herstellung eines Solarmoduls nach einem oder mehreren der vorangegangenen Ansprüche,
**dadurch gekennzeichnet,**
**dass** das elektrisch leitende Verbindungsmotiv eine Dicke von 0,5 µm bis 5000 µm und/oder eine Breite von 0,0001 mm bis 2000 mm aufweist.

4. Verfahren zur Herstellung eines Solarmoduls nach einem oder mehreren der vorangegangenen Ansprüche,
**dadurch gekennzeichnet,**
**dass** das elektrisch leitende Verbindungsmotiv direkt auf ein Glassubstrat aufgebracht wird.

5. Verfahren zur Herstellung eines Solarmoduls nach einem oder mehreren der vorangegangenen Ansprüche,
**dadurch gekennzeichnet,**
**dass** das Verbindungsmotiv so gestaltet ist, dass die Gestaltung des Verbindungsmotivs mindestens zwei darauf platzierte und/oder damit verbundene Solarzellen in Serie und/oder parallel schaltet.

6. Verfahren zur Herstellung eines Solarmoduls nach einem oder mehreren der vorangegangenen Ansprüche,
**dadurch gekennzeichnet,**
**dass** Verbindungsmotiv mindestens zwei bevorzugt durch die Gestaltung des Verbindungsmotivs in Serie und/oder parallel geschaltete Kontaktzonen aufweist.

7. Verfahren zur Herstellung eines Solarmoduls nach einem oder mehreren der vorangegangenen Ansprüche,
**dadurch gekennzeichnet,**
**dass** die Solarzellen durch elektrisch leitend Kleben und/oder Löten elektrisch mit dem Verbindungsmotiv verbunden werden.

8. Verfahren zur Herstellung eines Solarmoduls nach einem oder mehreren der vorangegangenen Ansprüche,
**dadurch gekennzeichnet,**
**dass** eine Polymerfolie zwischen dem Substrat und den Solarzellen und/oder zwischen den Solarzellen und der Glasscheibe angeordnet wird.

9. Verfahren zur Herstellung eines Solarmoduls nach einem oder mehreren der vorangegangenen Ansprüche,
**dadurch gekennzeichnet,**
**dass** das elektrisch leitende Verbindungsmotiv dank eines Sprüh- und/oder Spritzverfahrens beziehungsweise insbesondere dank eines thermischen Spritzverfahrens und/oder dank eines Kaltgasspritzverfahrens aufgebracht wird.

10. Verfahren zur Herstellung eines Solarmoduls nach einem oder mehreren der vorangegangenen Ansprüche,
**dadurch gekennzeichnet,**
**dass** das elektrisch leitende Verbindungsmotiv mit und/oder ohne Kaschierung aufgebracht wird.

11. Verfahren zur Herstellung eines Solarmoduls nach einem oder mehreren der vorangegangenen Ansprüche,
**dadurch gekennzeichnet,**
**dass** das elektrisch leitende Verbindungsmotiv in Zeilen aufgeteilt wird und/oder das elektrisch leitende Verbindungsmotiv progressiv Zeile für Zeile aufgebracht wird.

12. Verfahren zur Herstellung eines Solarmoduls nach Anspruche 11,
**dadurch gekennzeichnet,**
**dass** benachbarte Zeilen des Verbindungsmotivs nacheinander und/oder nicht nacheinander aufgebracht werden.

13. Solarmodul,
**dadurch gekennzeichnet,**
**dass** es ein Glassubstrat mit einem darauf haftend aufgebrachten Verbindungsmotiv umfasst.

14. Solarmodul,
**dadurch gekennzeichnet,**
**dass** das Verbindungsmotiv so gestaltet sein, dass die Gestaltung des Verbindungsmotivs mindestens zwei darauf platzierte und/oder damit verbundene Solarzellen in Serie und/oder parallel schaltet.

15. Verwendung eines Glassubstrats mit einem darauf haftend aufgebrachten Verbindungsmotiv zur Herstellung eines Solarmoduls.
